# EUROPEAN PATENT APPLICATION

(11) **EP 2 665 082 A1**
(43) Date of publication of application: **20.11.2013**
(21) Application number: 12168277.7
(22) Date of filing: 16.05.2012
(51) Int. Cl.: H01J 35/14, H01J 35/16, H01J 37/16, H01J 37/147

(54) **Element for fast magnetic beam deflection**

(71) Applicant: ICT Integrated Circuit Testing Gesellschaft für Halbleiterprüftechnik mbH, 85551 Heimstetten (DE)
(72) Inventor: Adamec, Pavel, 85540 Haar (DE); Salvesen, Carlo, 84323 Massing (DE)
(74) Representative: Zimmermann & Partner

(57) **Abstract**

A deflector system for fast magnetic deflection of a charged particle beam is described. The deflector system includes a tube for separating the beam from the magnetic deflector coil arrangement, the tube having a middle section, at least a first end section, and a second end section, wherein a wall thickness of the middle section is lower than a wall thickness of at least one of the first end section and the second end section.

## Description

### FIELD

Embodiments of the present invention relate to a charged particle beam device. In particular, they relate to a fast magnetic beam deflection system or scanning system. Specifically, embodiments relate to a deflector system for fast magnetic beam deflection, a beam device comprising a deflector system for fast magnetic beam deflection, a method of operating a deflector system for fast magnetic beam deflection and a method of manufacturing a deflector system for fast magnetic beam deflection.

### BACKGROUND

Charged particle beam apparatuses have many functions in a plurality of industrial fields, including, but not limited to, inspection of semiconductor devices during manufacturing, exposure systems for lithography, detecting devices and testing systems. Thus, there is a high demand for structuring and inspecting specimens within the micrometer and nanometer scale.

Micrometer and nanometer scale process control, inspection or structuring is often done with charged particle beams, e.g. electron beams, which are generated and focused in charged particle beam devices, such as electron microscopes or electron beam pattern generators. Charged particle beams offer superior spatial resolution compared to, e.g. photon beams, due to their short wavelengths.

The requirements of fast scanning are in particular important in applications of the manufacturing of semiconductors, where high throughput is essential. Such applications include electron beam inspection, defect review and critical dimension measurements.

Charged particle beam systems, such as a scanning electron microscope (SEM) can include a magnetic deflector system having a deflector coil and a liner element typically formed as a tube. The liner element separates an electron beam in a vacuum from the deflector coil placed usually outside of the vacuum. Existing magnetic deflector systems suffer from limitations coming from the creation of eddy currents around the magnetic deflector coil. These eddy currents are in particular problematic in the liner element through which the magnetic field created by the deflector coil needs to pass. On the one hand, the liner element could be made of a non-conductive material. However, this might hinder to define a potential distribution for the electron beam and suppress any potential charging that would cause beam instability. On the other hand, fast changes of the field create eddy currents in the conductive liner element that distort the deflection field and limit the achievable bandwidth.

Thus, there is a need for an improved magnetic deflection system. It is desired to provide a magnetic beam deflection system with improved scanning of the charged particle beam, particularly increased scanning speed and linearity.

### SUMMARY

In light of the above, a deflector system for fast magnetic beam deflection according to claim 1, a charged particle beam device comprising a deflector system for fast magnetic beam deflection according to claim 11, a method of operating a deflector system for fast magnetic beam deflection according to claim 12, and a method of manufacturing a deflector system for fast magnetic beam deflection according to claim 13 are provided.

According to one embodiment, a deflector system for fast magnetic deflection of a charged particle beam is provided. The deflector system includes a tube for surrounding the beam and a magnetic deflector coil arrangement. The tube has a middle section, at least a first end section, and a second end section, wherein a wall thickness of the middle section is 150 µm or below and is lower than a wall thickness of at least one of the first end section and the second end section.

According to another embodiment, a charged particle beam device, including a deflector system for magnetic beam deflection is provided. The deflector system includes a tube for surrounding the beam and a magnetic deflector coil arrangement. The tube has a middle section, at least a first end section and a second end section, wherein a wall thickness of the middle section is lower than a wall thickness of at least one of the first end section and the second end section.

According to a further embodiment, a method of operating a deflector system for magnetic deflection of a charged particle beam is provided. The method includes: providing a deflector system for magnetic deflection of a charged particle beam, comprising a magnetic deflector coil arrangement and a tube for separating the beam from the magnetic deflector coil arrangement, the tube having a middle section, at least a first end section, and a second end section, wherein a wall thickness of the middle section is lower than a wall thickness of at least one of the first end section and the second end section; applying an AC control current to the magnetic deflector coil arrangement having a frequency of 0.1-10 MHz.

According to an even further embodiment, a method of manufacturing a deflector system for magnetic deflection of a charged particle beam is provided. The method comprises: providing a magnetic deflector coil arrangement and a tube for separating the beam from the magnetic deflector coil arrangement, the tube having a middle section, at least a first end section, and a second end section, wherein a wall thickness of the middle section is lower than a wall thickness of at least one of the first end section and the second end section.

Further advantages, features, aspects and details that can be combined with the above embodiments are evident from the dependent claims, the description and the drawings.

Embodiments are also directed to apparatuses for carrying out the disclosed methods and including apparatus parts for performing each described method step. These method steps may be performed by way of hardware components, a computer programmed by appropriate software, by any combination of the two or in any other manner. Furthermore, embodiments are also directed to methods by which the described apparatus operates. It includes method steps for carrying out every function of the apparatus or manufacturing every part of the apparatus.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
Fig. 1 shows a schematic view of a deflector system according to an embodiment described herein;
Fig. 2a shows a schematic view of a tube according to an embodiment described herein;
Fig. 2b shows a schematic view of a tube according to an embodiment described herein;
Fig. 2c shows a schematic view of a tube according to an embodiment described herein; and
Fig. 3 shows a charged particle beam device comprising a deflector system according to embodiments described herein.
Fig. 4 shows a block diagram of a method for operating a deflector system according to embodiments described herein.

### DESCRIPTION OF THE PREFERRED EMBODIMENTS

Reference will now be made in detail to the various embodiments of the invention, one or more examples of which are illustrated in the figures. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

Within the following description of the drawings, the same reference numbers refer to the same components. Generally, only the differences with respect to the individual embodiments are described.

A "specimen" as referred to herein, includes, but is not limited to, semiconductor wafers, semiconductor workpieces, and other workpieces such as memory disks and the like. Embodiments of the invention may be applied to any workpiece on which material is deposited or which are structured. A specimen includes a surface to be structured or on which layers are deposited, for example, an edge, or more typically a bevel.

According to an embodiment, a deflector system for fast magnetic deflection of a charged particle beam is provided. The system comprises a tube for surrounding the beam and a magnetic deflector coil arrangement. The tube has a middle section, at least a first end section, and a second end section, wherein a wall thickness of the middle section is 150 µm or below and is lower than a wall thickness of at least one of the first end section and the second end section.

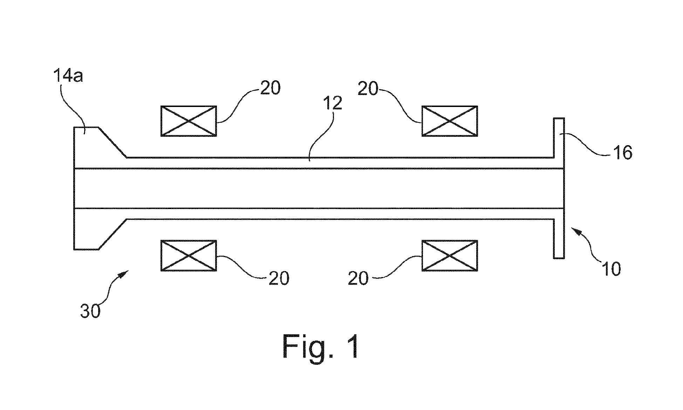

Fig. 1 shows a schematic view of a deflector system 30 according to an embodiment. A tube 10 is arranged within a magnetic deflector coil arrangement 20. Due to the low wall thickness of the middle section 12 of the tube 10, an improved penetration of the magnetic field through the tube 10 is achieved, leading to the reduction of eddy currents in the metal tube 10.

According to the embodiments, the end sections of the tube stabilize the manufactured structure and reinforce the tube typically at its both sides. Thus, a robust element is achieved with required performance and relatively simple manufacturing process.

According to an embodiment, a tube for a deflector system for fast magnetic deflection of a charged particle beam is provided. The tube has a middle section, and at least a first end section and a second end section, wherein a wall thickness of the middle section is lower than a wall thickness of at least one of the first end section and the second end section, typically of the first end section and the second end section.

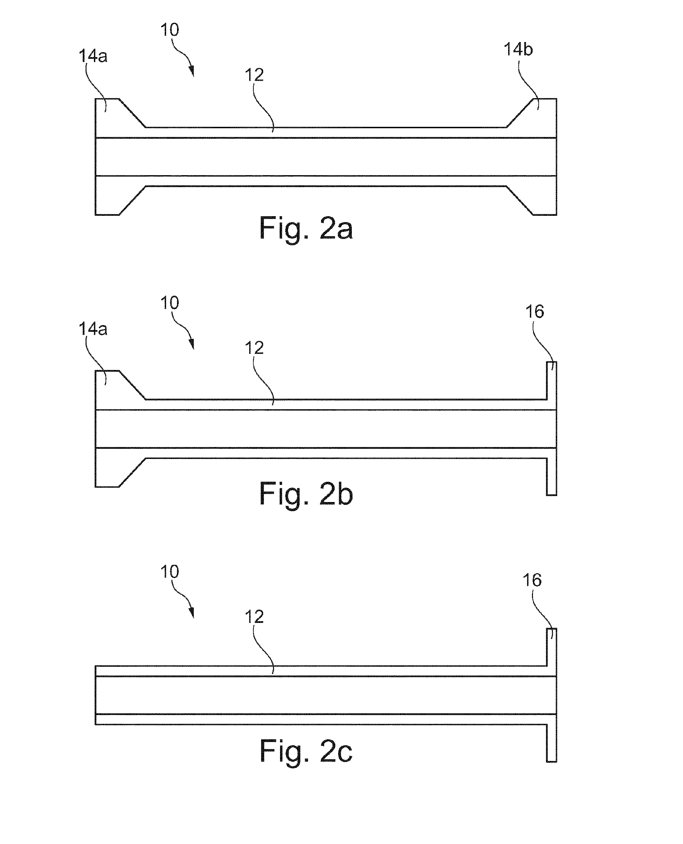

Fig. 2a shows a schematic view of a tube 10 according to an embodiment. The tube 10 has a middle section 12, a first end section 14a and a second end section 14b. The middle section 12 is shaped as a cylindrical tube. The first end section 14a and the second end section 14b are formed as reinforcement structures at both ends of the tube 10.

According to a further embodiment, the tube is made of a metal alloy, preferably with high resistivity. One example of such an alloy is TiAlV. According to some embodiments, Ti, Ni, and/or alloys therefrom can be suitable materials, e.g. Inconel or Hastelloy.

According to a further embodiment, the wall thickness of the middle section of the tube is typically in the range of 50 µm to 100 µm.

According to a further embodiment, at least one of the first end section and the second end section of the tube is shaped as a structure having a cylindrical fraction and a conical fraction. At least one of the cylindrical fraction and the conical fraction can be arranged coaxially with the middle section.

In the embodiment of Fig. 2a the first end section 14a and the second end section 14b are shaped as a structure having a cylindrical fraction and a conical fraction arranged coaxially with the middle section 12. A radial wall thickness of the cylindrical fraction is higher than the wall thickness of the middle section 12.

According to a further embodiment, at least one of the first end section and the second end section is shaped as a ring, e.g. with an annulus-like shape, arranged coaxially with the middle section.

Fig. 2b shows a schematic view of a tube 10 according to a further embodiment. The tube 10 has a middle section 12, a first end section 14a and a second end section 16. The middle section 12 is shaped as a cylindrical tube. According to typical implementations, the tube 10 can have a circular cross-section. However, the tube 10 may also have a square, a rectangular, a hexagonal cross-section or the like. The first end section 14a is shaped as a structure having a cylindrical fraction and a conical fraction. At least one of the cylindrical fraction and the conical fraction can be arranged coaxially with the middle section 12. A radial wall thickness of the cylindrical fraction is higher than the wall thickness of the middle section 12. The second end section 16 is shaped as a ring, e.g., arranged coaxially with the middle section 12. A radial wall thickness of the second end section 16 is higher than the wall thickness of the middle section 12.

Fig. 2c shows a schematic view of a tube 10 according to a further embodiment. The tube 10 has a middle section 12 and a second end section 16. The second end section 16 is shaped as a ring arranged coaxially with the middle section 12. A radial wall thickness of the second end section 16 is higher than the wall thickness of the middle section 12.

The end sections 14a, 14b, 16 of the tube 10 ensure stability which is especially important for low wall thickness of the middle section 12 of the tube 10.

According to a further embodiment, a charged particle beam device is provided, comprising a deflector system for magnetic beam deflection according to embodiments described herein.

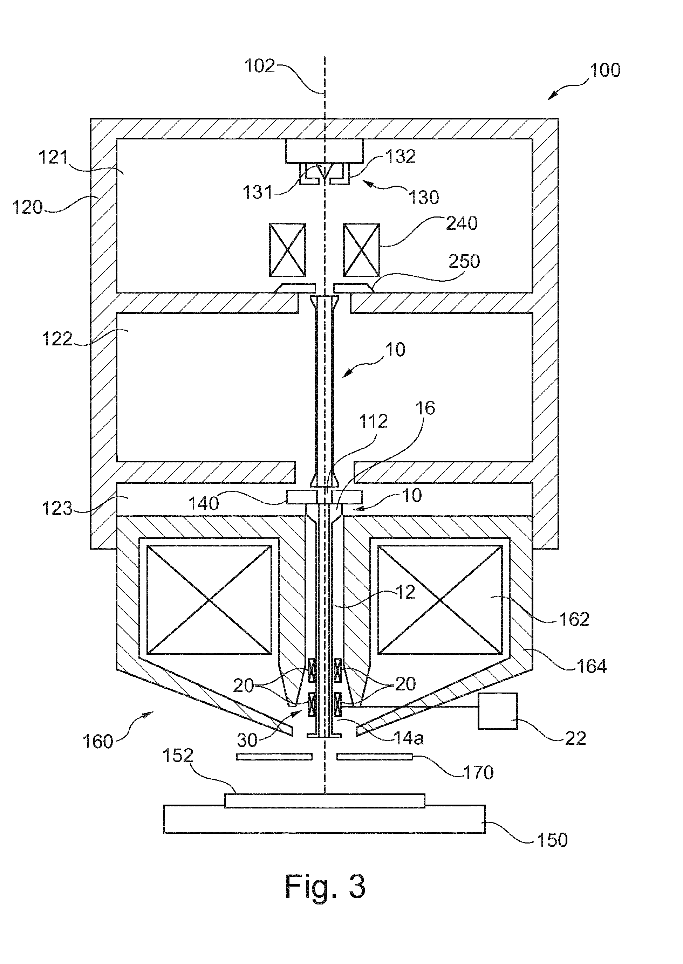

Fig. 3 shows a charged particle beam device 100 comprising a deflector system 30 according to embodiments. The charged particle beam column 120 provides a first chamber 121, a second chamber 122 and a third chamber 123. The first chamber, which can also be referred to as a gun chamber, includes a charged particle source 130 having an emitter 131 and suppressor 132. A charged particle beam is generated by the charged particle beam source 130, is aligned to the beam limiting aperture 250, which is dimensioned to shape the beam, i.e. blocks a portion of the beam, passes through opening 112 of the detector 140 and is focused on the specimen 152 positioned on a specimen position on the specimen stage 150. On impingement of the charged particle beam, for example, secondary or backscattered electrons are released from the specimen 152, which can be detected by the detector 140. A condenser lens 240 and a beam shaping or beam limiting aperture 250 are provided.

As shown in Fig. 3, according to some embodiments, a detector 140 can be provided above an objective lens 160 such that the primary charged particle beam passes through the opening 112 in the detector. The objective lens 160 having pole pieces 164 and a coil 162 focuses the charged particle beam on a specimen 152, which can be positioned on a specimen stage 150.

According to a further embodiment, a deflector system 30 is provided between the coil 162 of the objective lens 160 and the specimen 152. The deflector system 30 includes a tube 10 and a magnetic deflector coil arrangement 20. The tube 10 separates the charged particle beam in a vacuum from the deflector coil arrangement 20, placed outside of the vacuum. According to some embodiments described herein, which can be combined with other embodiments, the magnetic deflector coil arrangement 20 can be placed in air. A decelerating electrode 170 is provided at the exit of the charged particle beam device 100, between the objective lens 160 and the specimen 152. Thereby, the tube 10, the decelerating electrode 170 and the magnetic lens elements can form a combined magnetic-electrostatic lens. The deflector system 30 can further include a power supply 22, which is electrically connected to the magnetic deflector coil arrangement 20. The power supply 22 can be configured to provide an AC current of 0.1-10 MHz or above.

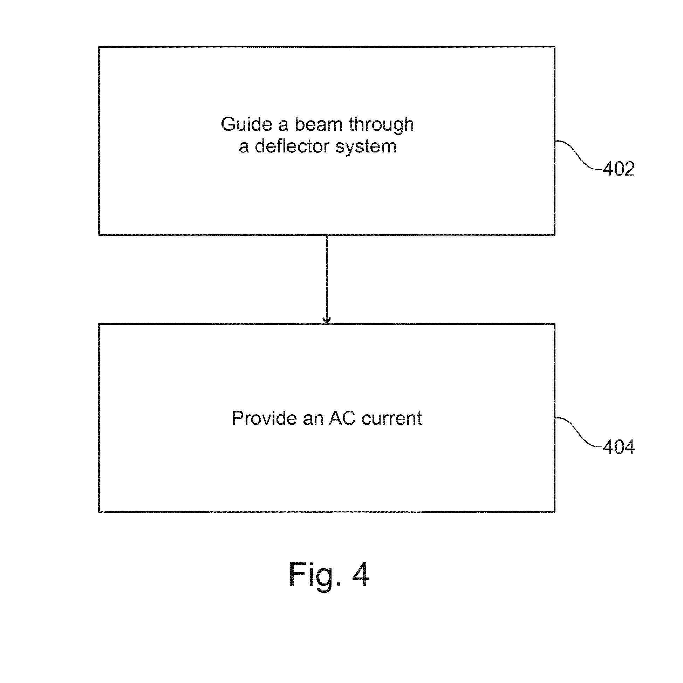

Fig. 4 shows a block diagram of a method for operating a deflector system according to embodiments described herein. In the first method step 402 the beam is guided through the deflector system as disclosed in the embodiments herein. In the next method step 404 an AC current is provided by a power supply to the magnetic coil arrangement. The current can have a frequency of 0.1-10 MHz or above.

According to some embodiments, a method of operating a deflector system for magnetic deflection of charged particle beam is provided. The method comprises: providing a deflector system for magnetic deflection of a charged particle beam, comprising a magnetic deflector coil arrangement and a tube for separating the beam from the magnetic deflector coil arrangement, the tube having a middle section, at least a first end section, and a second end section, wherein a wall thickness of the middle section is lower than a wall thickness of at least one of the first end section and the second end section; and applying an AC control current to the magnetic deflector coil arrangement having a frequency of 0.1-10 MHz.

According to a further embodiment, a method of manufacturing a deflector system for magnetic deflection of a charged particle beam is provided. The method comprises providing a magnetic deflector coil arrangement and a tube for separating the beam from the magnetic deflector coil arrangement, the tube having a middle section, at least a first end section, and a second end section, wherein a wall thickness of the middle section is lower than a wall thickness of at least one of the first end section and the second end section.

In light of the above, embodiments as described herein provide an arrangement which is capable of a more effective and accurate alignment as compared to common SEM tools. Thereby, the complexity of the alignment system is not increased and it might be possible that a more compact charged particle beam column can be provided.

While the foregoing is directed to embodiments of the invention, other and further embodiments of the invention may be devised without departing from the basic scope thereof, and the scope thereof is determined by the claims that follow.

## Claims

1. A deflector system (30) for fast magnetic deflection of a charged particle beam, the deflector system comprising:
a tube (10) for surrounding the beam, comprising a middle section (12), at least a first end section (14a), and a second end section (14b, 16), wherein a wall thickness of the middle section (12) is 150 µm or below and is lower than a wall thickness of at least one of the first end section (14a) and the second end section (14b, 16); and
a magnetic deflector coil arrangement (20).

2. The deflector system according to claim 1, wherein the tube (10) is made of a metal alloy.

3. The deflector system according to claim 2, wherein the metal alloy is TiAlV.

4. The deflector system according to any of the preceding claims, wherein the wall thickness of the middle section of the tube (10) is in the range of 50 µm to 100 µm.

5. The deflector system according to any of the preceding claims, wherein at least one of the first end section (14a) and the second end section (14b) is shaped as a structure having a cylindrical fraction and a conical fraction.

6. The deflector system according to claim 5, wherein at least one of the cylindrical fraction and the conical fraction is arranged coaxially with the middle section (12).

7. The deflector system according to any of the preceding claims, wherein at least one of the first end section and the second end section (16) is shaped as a ring.

8. The deflector system according to claim 7, wherein the ring is arranged coaxially with the middle section (12).

9. The deflector system according to any of the preceding claims, wherein the tube (10) is configured to separate the beam and the magnetic deflector coil arrangement (20).

10. The deflector system according to any of the preceding claims, further comprising a power supply (22) electrically connected to the magnetic deflector coil arrangement (20) and configured for providing an AC current of 0.1-10 MHz or above.

11. A charged particle beam device, comprising a deflector system (30) for fast magnetic deflection of a charged particle beam, according to any of preceding claims.

12. A method of operating a deflector system for magnetic deflection of charged particle beam, the method comprising:
providing a deflector system for magnetic deflection of a charged particle beam, comprising
a magnetic deflector coil arrangement (20) and
a tube (10) for separating the beam from the magnetic deflector coil arrangement, the tube having a middle section (12), at least a first end section (14a), and a second end section (14b, 16), wherein a wall thickness of the middle section (12) is lower than a wall thickness of at least one of the first end section (14a) and the second end section (14b, 16);
applying an AC control current to the magnetic deflector coil arrangement, having a frequency of 0.1-10 MHz.

13. A method of manufacturing a deflector system for magnetic deflection of a charged particle beam, the method comprising:
providing a magnetic deflector coil arrangement (20) and a tube (10) for separating the beam from the magnetic deflector coil arrangement, the tube having a middle section (12), at least a first end section (14a), and a second end section (14b, 16), wherein a wall thickness of the middle section (12) is lower than a wall thickness of at least one of the first end section (14a) and the second end section (14b, 16).
